(19) Europäisches Patentamt / European Patent Office / Office européen des brevets

(11) **EP 1 950 969 A2**

(12) **EUROPEAN PATENT APPLICATION**

(43) Date of publication:
**30.07.2008 Bulletin 2008/31**

(51) Int Cl.:
***H04N 7/24*** *(2006.01)*     ***H04H 60/12*** *(2008.01)*

(21) Application number: **07022694.9**

(22) Date of filing: **22.11.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK RS**<br><br>(30) Priority: **24.11.2006 KR 20060117026**<br>               **09.10.2007 KR 20070101545** | (71) Applicant: **Samsung Electronics Co., Ltd.**<br>**Suwon-si, Gyeonggi-Do (KR)**<br><br>(72) Inventor: **Kang, Young-Seok**<br>**Gyeonggi-do (KR)**<br><br>(74) Representative: **Lang, Johannes**<br>**Bardehle Pagenberg Dost Altenburg Geissler,**<br>**Postfach 86 06 20**<br>**81633 München (DE)** |

(54) **Digital broadcasting system and error correction method thereof**

(57) A digital broadcasting system and an error correction method thereof includes: a server to group a predetermined number of multicast packets to obtain Forward Error Correction (FEC) groups for digital broadcast data (MPEG TS) transmission, to create FEC data for each multicast packet using digital broadcast data (MPEG TS) of the multicast packets in the FEC groups, including the FEC data in the multicast packets, and to transmit the resultant multicast packets over a network; and a set-top box to recover digital broadcast data (MPEG TS) pieces of the digital broadcast data (MPEG TS) pieces of multicast packets other than the lost multicast packet in the FEC group to recover the lost multicast packet in response to a multicast packets received over the network being lost.

## FIG. 1

| ORIGINAL PACKET | A | B | C | D | E | • • • |
|---|---|---|---|---|---|---|
| FEC APPLIED | A | f(A,B) | B | f(B,C) | C | • • • |

**Description**

BACKGROUND OF THE INVENTION

Field of the Invention

The present invention relates to a digital broadcasting system and an error correction method thereof and, more particularly, the present invention relates to a digital broadcasting system and an error correction method thereof which correct a lost multicast packet through forward error correction.

Description of the Related Art

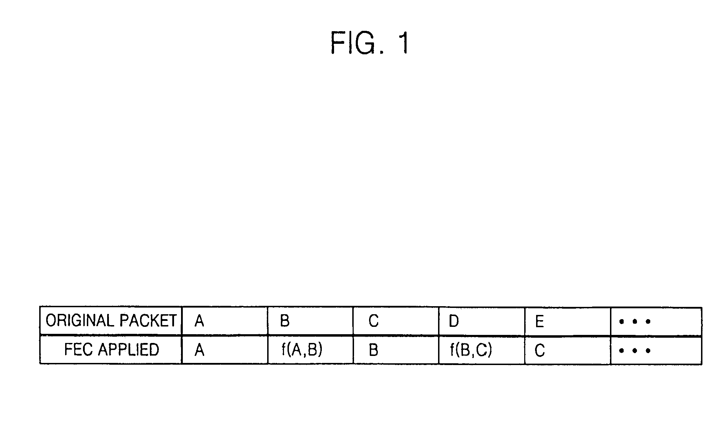

A digital broadcasting system efficiently compresses programs of a number of channels based on a Moving Picture Experts Group (MPEG) encoding standard, efficiently multiplexes the programs of the channels based on a digital modulation system of each transmission medium, and transmits the programs. Accordingly, the digital broadcasting system can broadcast tens to hundreds of channels without using many repeaters, unlike an analog broadcasting system.
Digital broadcasting may be classified into digital terrestrial broadcasting, digital satellite broadcasting, and cable digital broadcasting depending on transmission mediums. Contemporary digital satellite broadcasting has spread worldwide, and digital terrestrial broadcasting is being tested in the U.S. and some European countries.
Most digital broadcasting services are provided via cable. However, with recent developments in high-speed Internet technology, such digital broadcasting services can be provided over an Internet Protocol (IP) network.
A digital broadcasting system for providing digital broadcasting service includes a digital broadcast server for providing broadcast data over the IP network, and a number of set-top boxes connected to the IP network for providing the broadcast data from the digital broadcast server to users.
The digital broadcast server converts and compresses analog broadcast data received from a digital broadcasting station (a system operator) into digital broadcast data through encoding, and multicasts the resultant packets over the IP network. The multicast packet transferred over the IP network may be composed according to a Moving Picture Experts Group 2 (MPEG2) Transport Stream (TS) standard.
That is, the digital broadcast server multicasts broadcast data of any channel to the IP network.
The set-top box decodes and decompresses the multicast packet received over the IP network and provides the resultant digital broadcast data to a digital television.
As described above, the digital broadcast data is multicast from the digital broadcast server to the set-top box over the IP network. This multicasting does not allow the digital broadcast data (MPEG TS) to be retransmitted when it is lost on the IP network.
Accordingly, the digital television connected with the set-top box cannot reproduce the lost digital broadcast data. Instead, it displays noise in a reproduction area of a screen corresponding to the lost digital broadcast data.
To solve this problem, Forward Error Correction (FEC) is used. The FEC is a method of transmitting a number of FEC packets for lost-packet recovery together with a multicast packet stream of digital broadcast data (MPEG TS) and recovering a lost multicast packet by using a related FEC packet and packets adjacent to the lost multicast packet..
As shown in FIG. 1, FEC packets f(A, B) and f(B, C) are inserted between original multicast packet streams. Note that f(A, B)=A XOR B and f(B, C)=B XOR C.
That is, a digital broadcast server adds a number of FEC packets f(A, B) and f(B, C) between the original multicast packet streams A, B, C, D, E,... and multicasts the packets over an IP network.
A set-top box recovers a lost multicast packet in the multicast stream received from the digital broadcast server over the IP network by using the FEC packet needed to recover the lost multicast packet and a packet adjacent to the lost multicast packet.
For example, when a packet B in the multicast stream received from the digital broadcast server over the IP network is lost, the set-top box performs an exclusive OR (XOR) operation on an adjacent packet C and the FEC packet f(B, C) to recover the lost packet B.
As described above, the digital broadcast server adds the FEC packet between the multicast packet streams and transmits the resultant packet over the IP network, so that the set-top box recovers the lost packet B. However, the added FEC packet causes an increased overhead on the IP network.
For example, the added FEC packet as shown in FIG. 1 doubles an overhead on the IP network in comparison with an original multicast packet stream.
Furthermore, adding the FEC packet for lost-packet recovery requires the set-top box to have an FEC-packet processing component.

SUMMARY OF THE INVENTION

It is an object of the present invention to provide a digital broadcasting system and an error correction method thereof which reduce a network load by transmitting a multicast packet of a Forward Error Correction (FEC) group containing FEC data for lost-packet recovery.

A first aspect of the present invention provides a digital broadcasting system including a server to group a predetermined number of multicast packets to obtain Forward Error Correction (FEC) groups for digital broadcast data (MPEG TS) transmission, to create FEC data for each multicast packet using the digital broadcast data (MPEG TS) of the multicast packets in the FEC groups, including the FEC data in the multicast packets, and to transmit the resultant multicast packets over a network; and a set-top box to recover respective digital broadcast data (MPEG TS) pieces of the lost multicast packet through digital broadcast data (MPEG TS) pieces of multicast packets other than the lost multicast packet and combining the recovered digital broadcast data (MPEG TS) pieces to recover the lost multicast packet in response to a multicast packet received over the network being lost.

The server may include: a FEC group setter to group the predetermined number of multicast packets to obtain the multicast FEC groups for digital broadcast data (MPEG TS) transmission; a data fragmenter to fragment the digital broadcast data (MPEG TS) of the multicast packets in the FEC groups by the set number; an FEC data setter to fragment the respective digital broadcast data (MPEG TS) of the multicast packets in the FEC groups by the set number, to set the FEC data for each multicast packet through an exclusive OR (XOR) operation performed on the fragmented digital broadcast data (MPEG TS), including the FEC data in the multicast packets, and to transmit the resultant multicast packets over the network; and an FEC header setter to set a stream ID, a sequence number, and an order of each multicast packet in the FEC groups, and including the stream ID, the sequence number, and the order in each multicast packet.

The set-top box may determine whether there is a lost packet based on the sequence number.

A second aspect of the present invention provides a server for a digital broadcasting system, the server including: a Forward Error Correction (FEC) group setter to group a predetermined number of multicast packets to obtain FEC groups for digital broadcast data (MPEG TS) transmission; a data fragmenter to fragment the digital broadcast data (MPEG TS) of the multicast packets in the FEC groups by a set number; and an FEC data setter to fragment the digital broadcast data of the multicast packets in the FEC groups by a set number, to set FEC data for each multicast packet through an exclusive OR (XOR) operation performed on the fragmented digital broadcast data (MPEG TS), including the FEC data in the multicast packets, and to transmit the resultant multicast packets over the network.

The server may further include an FEC header setter to set a stream ID, a sequence number, and an order of each multicast packet in the FEC group and including the stream ID, the sequence number, and the order in each multicast packet.

A third aspect of the present invention provides a set-top box for a digital broadcasting system, the set-top box including: an error determiner to determine whether a multicast packet received over a network has been lost, based on a sequence number contained in each multicast packet; at least one buffer; and an error corrector to recover the lost multicast packet through recovery of Forward Error Correction (FEC) data of multicast packets other than the lost multicast packet in an FEC group.

A fourth aspect of the present invention provides a method of setting error correction information in a server for a digital broadcasting system, the method including: grouping a predetermined number of multicast packets to obtain FEC groups for digital broadcast data (MPEG TS) transmission; fragmenting digital broadcast data (MPEG TS) of the multicast packets in the FEC groups by a set number; and fragmenting digital broadcast data (MPEG TS) of the multicast packets in the FEC groups by a set number, setting Forward Error Correction (FEC) information for each multicast packet by using the fragmented digital broadcast data (MPEG TS), including the FEC data in the multicast packets, and transmitting the resultant multicast packets over a network.

Fragmenting digital broadcast data (MPEG TS) of the multicast packets in the FEC groups by a set number, setting FEC data for each multicast packet by using the fragmented digital broadcast data (MPEG TS), including the FEC data into the multicast packets, and transmitting the resultant multicast packets over a network may include setting FEC data for each multicast packet through an exclusive OR (XOR) operation performed on the fragmented digital broadcast data (MPEG TS).

The method may further include setting a stream ID, a sequence number, and an order of each multicast packet in the FEC groups, and including the stream ID, the sequence number, and the order in each multicast packet.

A fifth aspect of the present invention provides a method of error correction in a set-top box for a digital broadcasting system, the method including: determining whether a multicast packet received over a network has been lost, based on a sequence number contained in each multicast packet; and recovering digital broadcast data (MPEG TS) pieces of the lost multicast packet through FEC data of multicast packets other than the lost multicast packet in a EFC group and combining the recovered digital broadcast data (MPEG TS) pieces to recover the lost multicast packet.

BRIEF DESCRIPTION OF THE DRAWINGS

A more complete appreciation of the present invention, and many of the attendant advantages thereof, will be readily apparent as the present invention becomes better understood by reference to the following detailed description when considered in conjunction with the accompanying drawings, in which like reference symbols indicate the same or similar components, wherein:

FIG. 1 is a view of Forward Error Correction (FEC) for recovering a lost multicast packet in a digital broadcasting system;

FIG. 2 is a view of a digital broadcasting system according to an embodiment of the present invention;

FIG. 3 is a block diagram of an FEC server according to an embodiment of the present invention;

FIG. 4 is a block diagram of a set-top box according to an embodiment of the present invention;

FIG. 5 is a view of a multicast packet according to an embodiment of the present invention;

FIG. 6 is a view of an FEC header field of FIG. 5;

FIG. 7 is a view of fragmented digital broadcast data (MPEG TS) according to an embodiment of the present invention;

FIG. 8 is a view of an FEC field of multicast packets in an FEC group according to an embodiment of the present invention;

FIG. 9 is a flowchart of a method for setting FEC data in an FEC server according to an embodiment of the present invention;

FIG. 10 is a flowchart of a method of error correction in a set-top box according to an embodiment of the present invention; and

FIG. 11 is a flowchart of a process of recovering an FEC area of multicast packets in the method of error correction of the set-top box of FIG. 10.

DETAILED DESCRIPTION OF THE INVENTION

Hereinafter, exemplary embodiments of the present invention are described in detail with reference to the accompanying drawings. For the sake of clarity and conciseness, matters related to the present invention that are well known in the art have not been described.

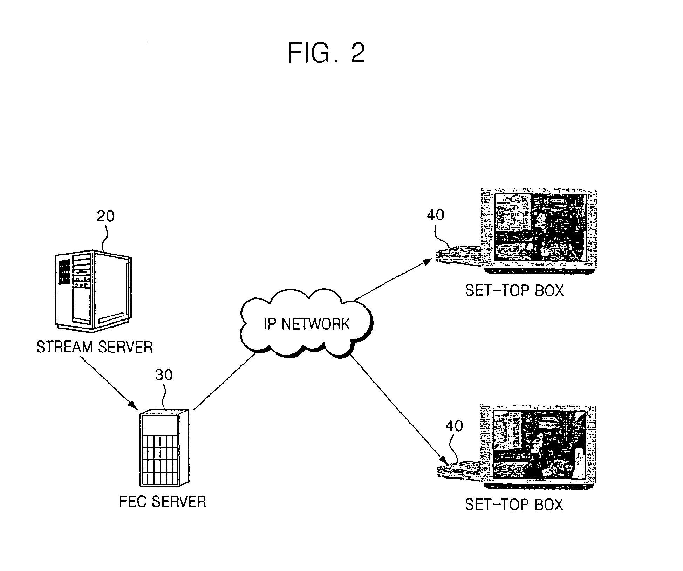

FIG. 2 is a view of a digital broadcasting system according to an embodiment of the present invention.

The original MPEG-TS is based on a cable broadcasting network. Accordingly, data is divided by a 188-byte unit and RS-CODE is added to the data for error correction upon transmission over a cable (Digital Video Broadcasting standard).

Then, most broadcasting equipment encodes the data by using MPEG-TS and, as a reference, most IP TVs use 1316 bytes, that is seven times the 188-byte unit, according to the MPEG-TS system.

Since one packet on the Ethernet consists of 1500 bytes at most, 156 bytes remains after the 1344 bytes are used.

Accordingly, in the present application, the remaining 156 bytes are used for the FEC field, thereby maximizing the performance of equipment set to use 1500 bytes.

Since the Ethernet equipment is set to use 1500 bytes, it cannot use more than 1500 bytes. Accordingly, the Ethernet equipment uses a size closest to 1500 bytes.

Referring to FIG. 2, the digital broadcasting system according to an embodiment of the present invention includes a stream server 20, an FEC server 30, and a number of set-top boxes 40.

The stream server 20 converts digital broadcast data (MPEG TS) provided by a broadcasting station (not shown) into multicast packets of an MPEG-TS format and provides the multicast packets to the FEC server 30.

The FEC server 30 groups the multicast packets from the stream server 20 by a predetermined number (e.g., 10) to obtain FEC groups, subtracts 1 from the number of multicast packets in the FEC group, and divides the size of the digital broadcast data (MPEG TS) included in the multicast packet by the subtraction result value to obtain a fragment size "fragment_size".

The FEC server 30 creates FEC data for each multicast packet required for recovering a lost multicast packet by using the number of the multicast packets in the FEC group and the fragment size, includes the generated FEC data in the corresponding multicast packet, and multicasts the resultant multicast packet to the set-top box 40 over the IP network.

The set-top box 40 decodes and decompresses the multicast packet received over the IP network and provides the resultant digital broadcast data to the digital television.

When any of the multicast packets received over the IP network is lost, the set-top box 40 recovers the lost multicast packet by using the FEC data contained in the multicast packet corresponding to an FEC group.

That is, when any of the multicast packets received over the network is lost, the set-top box 40 recovers respective pieces of the lost digital broadcast data (MPEG TS) through FEC data of multicast packets other than the lost multicast packet and combines the recovered digital broadcast data (MPEG TS) pieces to recover the lost multicast packet.

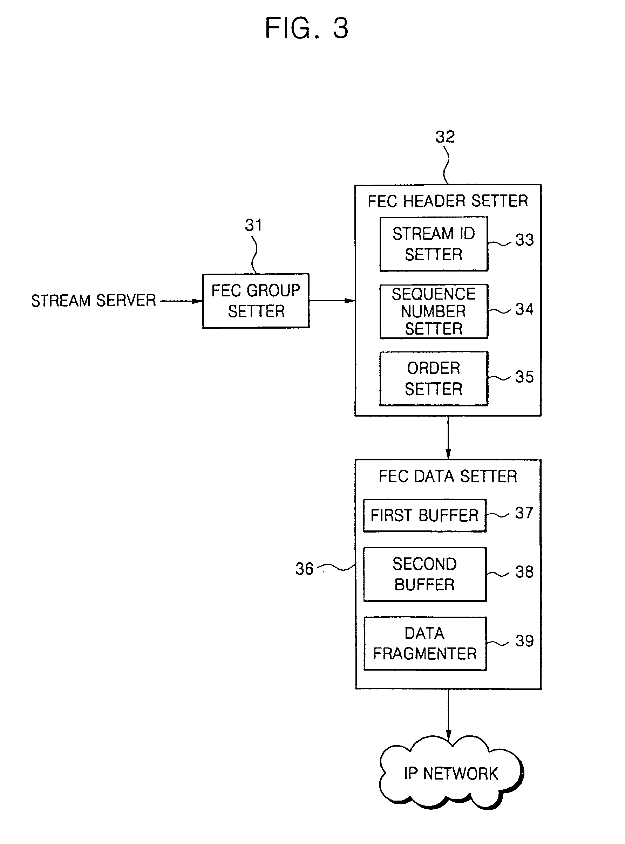

FIG. 3 is a block diagram of an FEC server according to an embodiment of the present invention.

Referring to FIG. 3, the FEC server includes an FEC group setter 31, an FEC header setter 32, and an FEC data setter 36. The FEC header setter 32 includes a stream ID setter 33 and an order setter 35. The FEC data setter 36 includes a data fragmenter 39.

The FEC group setter 31 groups the multicast packets received from a stream server by the set number (e.g., 10) to obtain FEC groups.

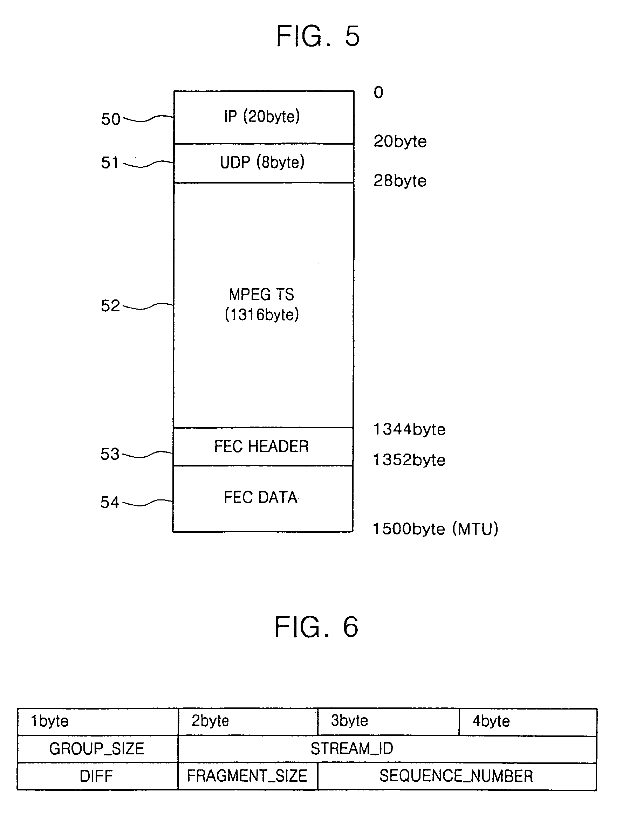

A format of the multicast packet from the stream server is shown in FIG. 5.

As shown in FIG. 5, the multicast packet includes an IP address field 50, a UDP field 51, a digital broadcast data (MPEG TS) field 52, an FEC header field 53, and an FEC data field 54.

The IP address field 50 includes an IP address of the stream server, which is a source for generating the multicast packet, and an FEC group address to which the multicast packet is to be transmitted. The IP address field 50 consists of 20 bytes.

The UDP field 51 indicates that the multicast packet is transferred through UDP protocol. The UDP field 51 consists of 8 bytes.

The digital broadcast data (MPEG TS) field 52 includes digital broadcast data (MPEG TS) and consists of 1316 bytes.

The FEC header field 53 includes FEC settings created for recovery of a lost multicast packet, and consists of 8 bytes.

The FEC data field 54 includes FEC data created for recovery of the lost multicast packet and has a "fragment_size "size of FIG. 6.

FIG. 6 is a view of information used in creating the FEC data of the multicast packet and information capable of tracking information on the lost packet, which are required for recovery of the lost packet by the set-top box.

Referring to FIG. 6, the FEC header includes an FEC group size group_size, a stream ID stream_ID, an order diff of a multicast packet in an FEC group, a fragment size fragment_size, and a sequence number.

The FEC group size group_size corresponds to the number of multicast packets in the FEC group. The FEC group is a group of pieces of digital broadcast data (MPEG TS) of multicast packets associated with each other through an exclusive OR operation, which will be used in composing the FEC data. For example, when one multicast packet is lost, a digital broadcast data (MPEG TS) portion of the lost multicast packet is recovered with all other multicast packets in the FEC group. Because recovering one lost multicast packet per FEC group is allowed, a smaller FEC group size provides a good recovery rate, but increases the overhead on the network.

The stream ID stream_ID indicates an ID for identifying digital broadcast data (MPEG TS) included in the multicast stream.

The order diff of a first multicast packet in an FEC group is 0, the order diff of a second packet is 1, ... , the order diff of the last packet is group_size-1.

The fragment size fragment_size indicates a size by which the digital broadcast data (MPEG TS) is fragmented to create FEC data, and it corresponds to the size of the FEC data.

The sequence number indicates a number assigned to each multicast packet, and is used for recognizing a lost multicast packet.

A method of setting the FEC header field and the FEC data of FIG. 5 is described as follows.

FIG. 6 is a view of the FEC header field.

First, the FEC group size group_size is determined. The FEC group size may be arbitrarily selected from a range of from 10 to 255 depending on a network state.

Because recovering one lost multicast packet per FEC group is allowed, a smaller FEC group size provides a good recovery rate, but increases the overhead on the network, which requires an operator to select a proper group size.

In the description below, the FEC group size is assumed to be 10.

When the FEC group size is defined, the FEC header setter 32 sets the defined value in the group_size field and defines the fragment size fragment_size as a positive integer ranging from 1316/(group_size-1) to 148.

$$1316 / (group\_size-1) ? fragment\_size ? 148$$

The stream ID setter 33 in the FEC header setter 32 then records a stream ID stream_ID.

One stream ID stream_ID is set for each channel of a digital broadcast stream and defined as any value by the operator. In the set-top box, since the sequence number sequence_number is recognized for streams having the same stream ID value in order to check whether the multicast packet is lost, the stream ID must be defined not to overlap between channels.

When the stream ID has been set, the sequence number setter 34 then sets sequence numbers sequence_number of the multicast packets belonging to the FEC group according to the order of the digital broadcast data (MPEG TS). In the set-top box, the sequence number sequence_number is set for recognizing whether a multicast packet is lost and has a value of 0, 1, 2, ..., 65535. Following the maximum value of 65535, 0 is set as the sequence number for the multicast packet.

When the sequence number has been set, the order setter 35 in the FEC header setter 32 then sets the orders of the multicast packets included in the FEC group. The orders diff of the multicast packets in the group reflect distances from a first packet in the FEC group. The order of the first packet in the FEC group is 0, the order of a second packet is 1, ... , the order of the last packet is group_size-1.

After setting the orders of the multicast packets in the FEC group, the FEC header setter 32 includes the set stream ID, each sequence number, the group size, the multicast packet order diff, and the fragment size in the FEC header of each multicast packet.

A method of setting the FEC data field of FIG. 5 is described as follows.

The FEC data field 54 stores data created by the FEC data setter 36. When the FEC header setter 32 has set the information in the FEC header of each multicast packet, the FEC data setter 36 fragments the digital broadcast data (MPEG TS) included in the multicast packet, based on the fragment size fragment_size set in the FEC header.

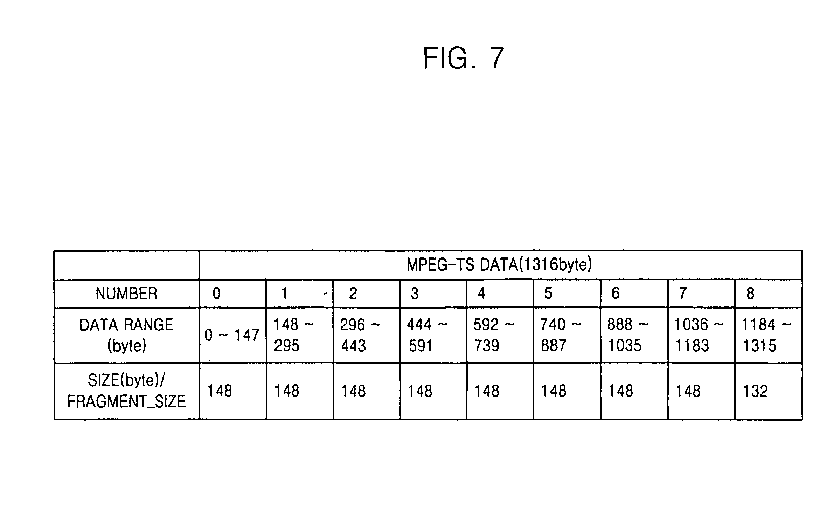

The digital broadcast data (MPEG TS) fragmented by the fragment size is shown in FIG. 7. FIG. 7 is a view of the digital broadcast data (MPEG TS) fragmented when the fragment size fragment_size is 148. It can be seen that the digital broadcast data (MPEG-TS) is fragmented into nine 148-byte pieces by the fragment size fragment_size of 148.

After fragmenting the digital broadcast data (MPEG TS) into the fragment size pieces, the FEC data setter 36 obtains FEC data to be inserted into the FEC data area of the multicast packet shown in FIG. 5.

Specifically, the FEC data setter 36 fragments the digital broadcast data (MPEG TS) into pieces and then initializes a first buffer 37 and a second buffer 38. Preferably, the first buffer 37 and the second buffer 38 have the fragment sizes.

When the order n of the multicast packet in the FEC group for recovering the FEC data does not match the order diff of the multicast packet for extracting the digital broadcast data (MPEG TS) piece, the FEC data setter 36 stores the "(diff-1)-th digital broadcast data (MPEG TS) piece of the multicast packet n in the second buffer 38.

The FEC data setter 36 performs an exclusive OR (XOR) operation on the FEC data stored in the first buffer 37 and the digital broadcast data (MPEG TS) piece stored in the second buffer 38, and stores the resultant value in the first buffer 37.

When the order n of the multicast packet in the FEC group for recovering the FEC data matches the order diff of the multicast packet for extracting the digital broadcast data (MPEG TS) piece, the FEC data setter 36 increments the order diff of the multicast packet by a set value of 1 in order to extract a digital broadcast data (MPEG TS) piece of a next multicast packet. That is, the multicast packet n is stored with "diff+1" to extract the next digital broadcast data (MPEG TS) piece.

On the other hand, when the counter (n) order of the multicast packet increased by the set value does not match the FEC group size, the FEC data setter 36 stores, in the second buffer 38, the diff-th digital broadcast data (MPEG TS) piece of the multicast packet corresponding to the counter (n) order.

The FEC data setter 36 performs an XOR operation on the FEC data of the multicast packet n stored in the first buffer 37 and the digital broadcast data (MPEG TS) piece stored in the second buffer 38 and stores the resultant value in the first buffer 37.

When the current order (n=diff+1) of the multicast packet in the FEC group matches the FEC group size, the FEC data setter 36 inserts the value stored in the first buffer 37 in the FEC data area.

After inserting the value stored in the first buffer 37 into the FEC data area, the FEC data setter 36 multicasts the resultant multicast packet over the IP network.

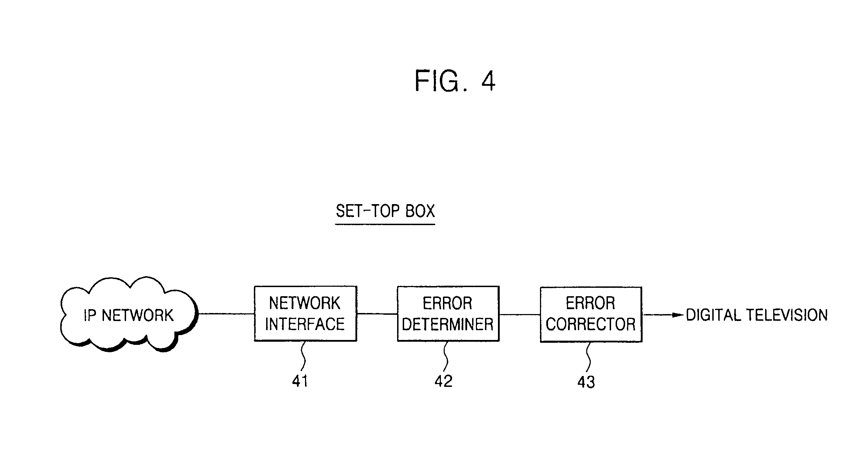

FIG. 4 is a block diagram of a set-top box according to an embodiment of the present invention.

Referring to FIG. 4, the set-top box 40 includes a network interface 41, an error determiner 42, and an error corrector 43.

The error determiner 42 receives a stream of multicast packets over the IP network and determines whether any of the multicast packets is lost based on the sequence number. When it has been determined that a multicast packet is lost, the error determiner 42 controls the error corrector 43 to recover the lost multicast packet.

In order to recover the digital broadcast data (MPEG TS) contained in the lost multicast packet, the error corrector 43 recovers the digital broadcast data (MPEG TS) piece of the lost multicast packet through the FEC data of multicast packets other than the lost multicast packet in the FEC group and combines the recovered digital broadcast data (MPEG TS) pieces to recover the digital broadcast data (MPEG TS) of the lost multicast packet.

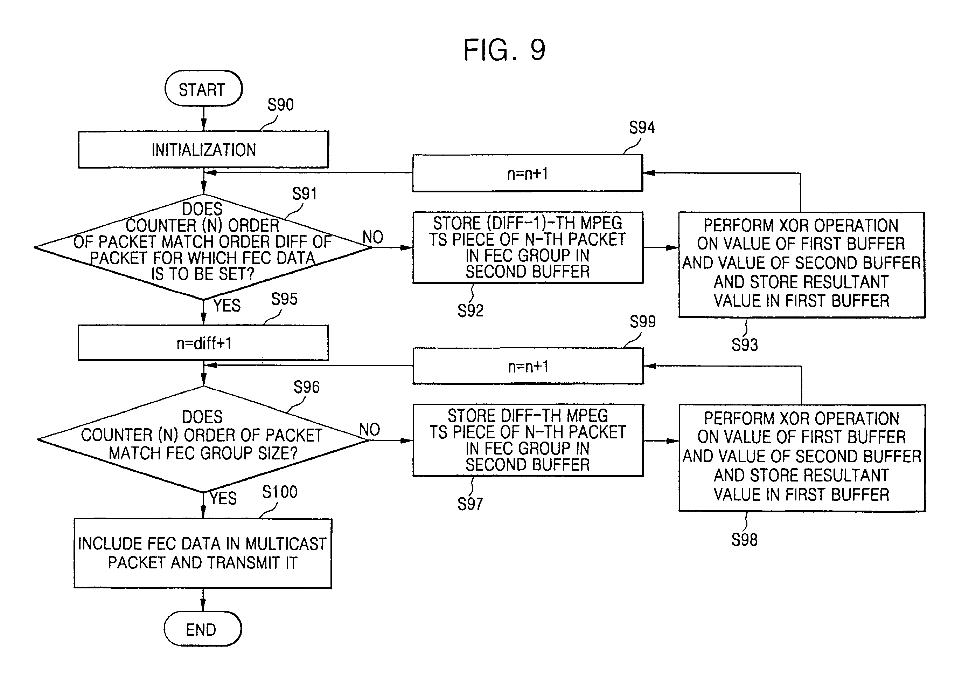

FIG. 9 is a flowchart of a method of setting FEC data at the FEC server according to an embodiment of the present invention.

As shown in FIG. 9, the FEC server initializes the first buffer 37, the second buffer 38, and the counter (n) order of the multicast packet in the FEC group (S90). Preferably, the first buffer 37 and the second buffer 38 have the fragment size.

The FEC server determines whether diff of the packet for setting the FEC data matches the counter n of FIG. 9 (S91). Note that diff indicates a diff value for creating the FEC data set in FIG. 6, which is fixed until the flow ends. The counter 'n' indicates a value of a counter which performs an XOR operation "group_size-1" times on the digital broadcast data (MPEG TS) to create the FEC data.

When the counter (n) order of the multicast packets in the FEC group does not match the multicast order diff in the FEC group of the multicast packet for which the FEC data is to be set, the FEC server stores, in the second buffer 38, the order (diff-1)-th digital broadcast data (MPEG TS) piece of the multicast packet n corresponding to the counter (n) order in the FEC group (S92).

The FEC server performs an XOR operation on the digital broadcast data (MPEG TS) piece stored in the first buffer 37 and the digital broadcast data (MPEG TS) piece stored in the second buffer 38 and stores the resultant value in the first buffer 37 (S93).

The FEC server increments the counter n by 1 to extract a digital broadcast data (MPEG TS) piece of a next multicast packet and returns to step S91 (S94).

When the counter (n) order of the multicast packet in the FEC group matches the multicast order diff in the FEC group of the multicast packet for which the FEC data is to be set, the FEC server sets the multicast packet n from which the digital broadcast data (MPEG TS) piece is to be extracted, to "diff+1" by incrementing the order diff of the multicast packet for which the FEC data is to be set, by 1 (S95). That is, the FEC server sets 'n' to the "diff+1" value to select a next multicast packet when "n" becomes equal to "diff" because the digital broadcast data (MPEG TS) piece in the first buffer to be subject to the XOR operation is the same as a multicast packet that will compose the FEC data.

The FEC server determines whether the counter n of the multicast packet increased by the set value matches the FEC group size (S96).

When it has been determined that the current order (n=diff+1) of the multicast packet increased by the set value does not match the FEC group size, the FEC server stores, in the second buffer 38, the digital broadcast data (MPEG TS) piece corresponding to the order diff of the multicast packet for which the FEC data is to be set, among the fragmented digital broadcast data (MPEG TS) pieces of the multicast packet corresponding to the current order (n=diff+1) of the multicast packet increased by the set value (S97).

The FEC server performs the XOR operation on the digital broadcast data (MPEG TS) piece stored in the first buffer 37 and the digital broadcast data (MPEG TS) piece stored in the second buffer 38, and stores the resultant value in the first buffer 37 (S98).

The FEC server increments the counter n by 1 and then returns to step S96 to extract a digital broadcast data (MPEG TS) piece of a next multicast packet (S99).

Meanwhile, when it has been determined that the current order (n=diff+1) of the multicast packet in the FEC group matches the FEC group size, the FEC server inserts the value stored in the first buffer 37 into the FEC data field. The FEC server then multicasts the resultant multicast packet over the IP network (S 100).

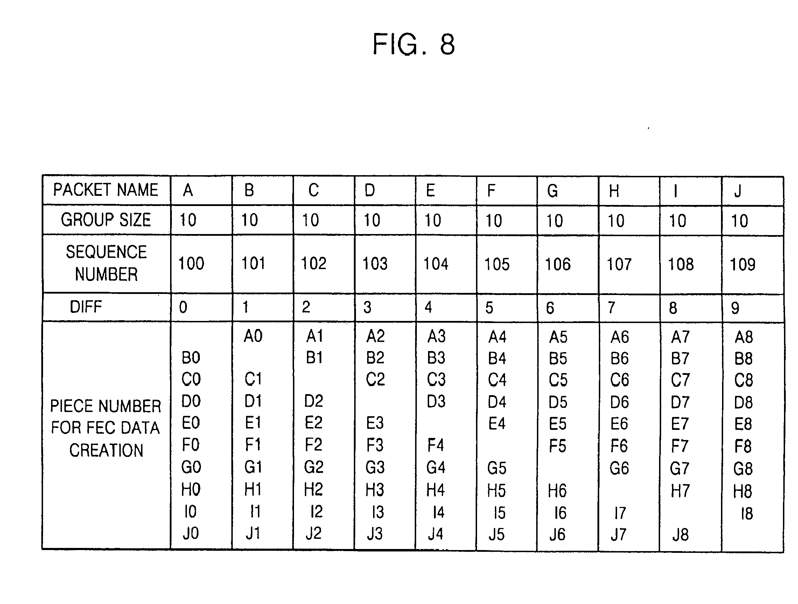

The method of setting the FEC data in the FEC server according to an embodiment of the present invention is described in greater detail below with reference to FIG. 8.

FIG. 8 is a view of an FEC field of multicast packets in an FEC group according to an embodiment of the present invention.

It can be seen from FIG. 8 that the FEC group includes ten multicast packets from A to J. Accordingly, the FEC group size is "10". The sequence numbers from 100 to 109 are set in the multicast packets in the FEC group.

In the FEC group, an order of the multicast packet A is "0", an order of the multicast packet B is "1",..., and an order of the multicast packet J is "9".

The digital broadcast data (MPEG TS) pieces for creating the FEC data of the multicast packets in the FEC group are illustrated. For example, it can be seen that the digital broadcast data (MPEG TS) pieces for creating the FEC data of the multicast packet A include B0, C0, D0, E0, F0, G0, H0, I0, and J0. In B0, B indicates the multicast packet B and "0" indicates the first digital broadcast data (MPEG TS) piece of the multicast packet B.

The method of setting FEC is described below with reference to FIG. 9. It is assumed that FEC data of the multicast packet C is set.

The FEC server initializes the first buffer 37, the second buffer 38, and the counter (n) order of the multicast packet in the FEC group (S90). Preferably, the first buffer 37 and the second buffer 38 have the fragment size.

The FEC server determines whether the counter (n) order of the multicast packet in the FEC group matches the multicast packet order diff for setting the FEC data (S91).

Since the current order (n=0) of the multicast packet in the FEC group does not match the multicast order (diff=2) in the FEC group of the multicast packets for which the FEC data is to be set, the FEC server stores, in the second buffer 38, a digital broadcast data (MPEG TS) piece A1 corresponding to the order diff=2 of the multicast packet for which the FEC data is to be set, among the digital broadcast data (MPEG TS) pieces of the multicast packet A corresponding to the current order (n=0) in the FEC group (S92).

The FEC server performs an XOR operation on the digital broadcast data (MPEG TS) piece stored in the first buffer 37 and the digital broadcast data (MPEG TS) piece stored in the second buffer 38, and again stores the resultant value in the first buffer 37 (S93).

The FEC server then increments the counter (n) order of the multicast packet in the FEC group by the set number "1" and returns to step S91 (S94).

Since in step S91, the counter (n) order of the multicast packet becomes '1' and the order diff of the multicast packet for which the FEC data is to be set is '2', the FEC server then proceeds to step S92.

That is, the FEC server stores a second digital broadcast data (MPEG TS) piece B 1 of the multicast packet B in the second buffer 38 (S92).

The FEC server then performs the XOR operation on the value of the first buffer 37 and the value of the second buffer 38.

In this case, the value stored in the first buffer 37 is the result of operation "0 XOR A 1 XOR B1".

The FEC server then increments the counter (n) order of the multicast packet by "1" and returns to step S91.

Since it has been determined in step S91 that the counter (n) order of the multicast packet is "2" matches the order diff "2"of the multicast packet for which the FEC data is to be set, the FEC server proceeds step S95.

The FEC server increments the order diff "2" of the multicast packet for which the FEC data is to be set by the set number "1" and stores the resultant value as the counter (n) order of the multicast packet (S95). Accordingly, the order diff of the multicast packet for which the FEC data is to be set becomes "3". That is, the order of the multicast packet for which the FEC data is to be set becomes '3' since it is "diff(2)+1".

The FEC server checks whether the order n of the multicast packet in which the FEC data "3" matches the FEC group size (S96).

Since the order (n) "3" of the multicast packet for which the FEC data is to be set does not match the FEC group size "10", the FEC server proceeds to step S97.

Accordingly, the FEC server stores a third digital broadcast data (MPEG TS) piece D2 of the multicast packet D in the second buffer 38 and proceeds to step S98.

The FEC server performs an XOR operation on the value of the first buffer 37 and the value of the second buffer 38 and again stores the resultant value in the first buffer 37 (step S98). The value stored in the first buffer 37 is the result of operation "0 XOR A1 XOR B1 XOR D2".

The FEC server increments the counter (n) order of the multicast packet by "1" (S99) and returns to step S96.

Then, the FEC server repeatedly performs steps S96 to S99 until the counter (n) order of the multicast packet matches the FEC group size.

When the current order of the multicast packet in the FEC group matches the FEC group size by repeatedly performing steps S96 to S99, the FEC server inserts the value stored in the first buffer 37 into the FEC data field (S 100). The FEC server then multicasts the multicast packet over the IP network.

The value inserted into the FEC data field is the resultant value of the operation "0 XOR A1 XOR B1 XOR D2 XOR E2 XOR F2 XOR G2 XOR H2 XOR 12 XOR J2".

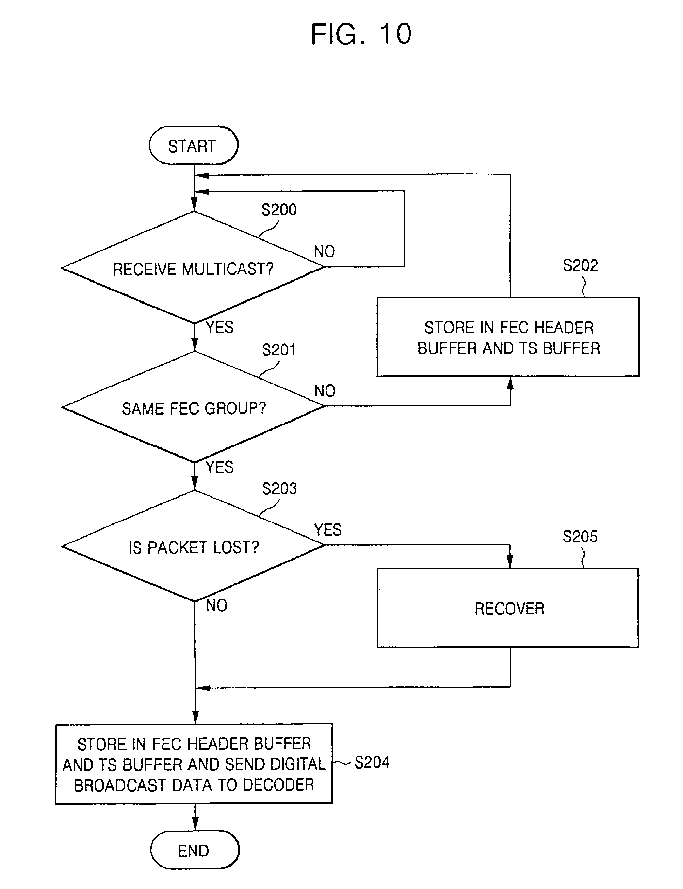

FIG. 10 is a flowchart of a method of error correction in a set-top box according to an embodiment of the present invention.

The set-up box waits until all of the multicast packets in the FEC group have been received.(S200).

When a multicast packet has been received, FEC header information of the received multicast packet is compared with that of an immediately previous received multicast packet to check whether the FEC group is changed. Meeting the following equation implies that the FEC group is not changed.

$$\{now(sequence\_number) - pre(sequence\_number)\} - \{now(diff) - pre(diff)\} = 0$$

where pre(x) indicates an x field of an FEC header of the immediately previous packet and now(x) indicates an x field of an FEC header of the current packet.

When it has been determined in step S201 of FIG. 10 that the multicast packets belong to the same FEC group, the digital broadcast data (MPEG TS) is stored in a TS buffer (not shown) and the header information is stored in an FEC header buffer (S202).

When it has been determined in step S201 of FIG. 10 that the multicast packets do not belong to the same FEC group, contents in the FEC header buffers are compared with each other to check whether there is a lost packet in the FEC group (S203).

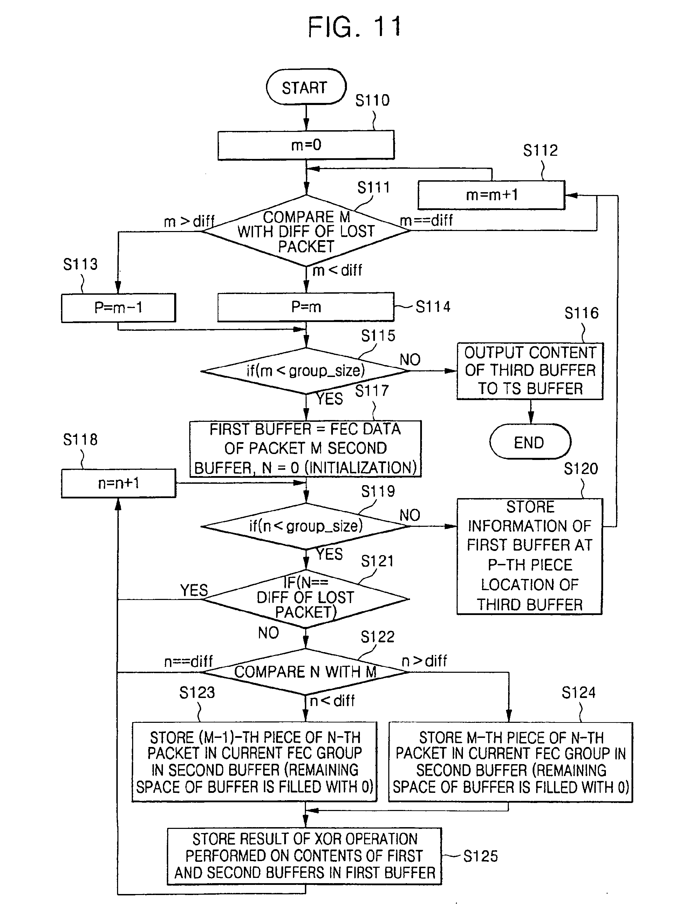

When it has been determined in step S203 of FIG. 10 that there is one lost packet, the process proceeds to step S204 of FIG. 11 via a recovery step S205, and when it has been determined that there is no lost packet or there are more than one lost packet, the process proceeds to step S204.

In step S204 of FIG. 10, the digital broadcast data (MPEG TS) and FEC header information of the current packet are stored in the respective buffers, as in step S202, and digital broadcast data (MPEG TS) in a previous FEC group is sent to a decoder.

FIG. 11 is a flowchart of a process of recovering the lost multicast packet in step S 105 of FIG. 10.

Note that 'm' is stored in the first buffer. 'm' indicates a number of a multicast packet having an FEC area to be recovered and ranges from 0 to "group_size-1".

Recovering the lost packet requires information about all other multicast packets in the same FEC group, which are indicated by 'm'.

'P' indicates a location of the piece recovered. That is, since the digital broadcast data (MPEG TS) is divided by the fragment size in creating the FEC data, the number of divided pieces becomes group_size-1. The thus divided pieces are shown in FIG. 7, in which 'P' indicates a piece number.

Note that 'n' is also stored in the second buffer. 'n' indicates a count of multicast packets required for recovery of the digital broadcast data (MPEG TS) piece and ranges from 0 to group_size-1.

For recovery of the lost packet, a 'P'-th piece of a specific packet 'm' is recovered as follows:

FEC data is extracted from the 'm'-th packet and a specific piece of the digital broadcast data (MPEG TS) is extracted from all other packets. They are then subject to an XOR operation to recover the 'P'-th piece. In this case, the multicast packets other than the 'm'-th multicast packet are sequentially selected by the counter 'n'.

First, the count 'm' is set to '0' to select the multicast packet m to be stored in the first buffer (S110). It indicates that an order of the multicast packet to be first recovered is diff '0'.

'm' indicating the multicast packet to be stored in the first buffer is compared with diff of the lost packet (S111).

When it has been determined in step S111 that 'm' is smaller than diff of the lost packet, a piece number P equal to 'm' is specified as a storage location of the third buffer (S114).

When it has been determined in step S111 that 'm' is greater than diff of the lost packet, the piece number (P) of 'm'-1 is specified as the storage location of the third buffer (S113).

The piece location of the packet recovered is determined in steps S 113 and S114.

A determination is then made as to whether 'm' is smaller than group_size (S115).

If 'm' is smaller than group_size, the first buffer is initialized into the digital broadcast data (MPEG TS) piece of the packet m, and the second buffer and 'n' are initialized into '0' (S 117).

A determination is then made as to whether the multicast packet 'n' to be stored in the second buffer is smaller than group_size (S 119).

If the multicast packet 'n' is smaller than group_size, a determination is made as to whether the multicast packet n to be stored in the second buffer is not same as diff of the lost packet (S121).

If the multicast packet n to be stored in the second buffer is not the same as diff of the lost packet, the multicast packet m to be stored in the first buffer is compared with the multicast packet n to be stored in the second buffer (S 122).

If the multicast packet n is smaller than the multicast packet m, the (m-1)-th digital broadcast data (MPEG TS) piece of the 'n'-th multicast packet in the current FEC group is stored in the second buffer (S123). A remaining space of the buffer is filled with '0'.

On the other hand, if the multicast packet n is greater than the multicast packet m, the m-th digital broadcast data (MPEG TS) piece of the 'n'-th multicast packet in the current FEC group is stored in the second buffer (S 124). A remaining space of the buffer is filled with '0'.

Contents of the first and second buffers are then subject to the XOR operation and the result is stored in the first buffer (S125).

A multicast packet n+1 is then processed (S118). That is, a piece extracted from a next packet is stored in the second buffer.

Steps S119, S121, S122, S123 or S 124, and S125 are performed. When it has been determined in step S119, where a determination is made as to whether the multicast packet 'n' is smaller than group_size, that the multicast packet 'n' is made the same as group_size, the information in the first buffer is stored at the P-th piece location of the third buffer (S 120). That is, the digital broadcast data (MPEG TS) piece is recovered in one multicast packet in the FEC group.

A multicast packet m+1 is then processed (S 112). That is, FEC data of the next multicast packet is recovered.

The process then proceeds to step S111 where 'm' indicating the packet to be recovered is compared with diff of the lost packet.

The above steps are repeatedly performed.

When it has been determined in step S 115, where a determination is made as to whether 'm' is smaller than group_size, that 'm' is the same as group_size, the content of the third buffer is output to the TS buffer. That is, this means that all of the lost packets have been recovered.

When it has been determined in step S 121, where the multicast packet n to be stored in the second buffer is not the same as diff of the lost packet, that the multicast packet n to be stored in the second buffer is the same as diff of the lost packet, the multicast packet n is incremented by 1 so that the next multicast packet is stored in the second buffer (S 118) and then the process proceeds to step S 119. This is to perform an operation on the next packet since the digital broadcast data (MPEG TS) piece cannot be extracted from the lost packet.

On the other hand, when it has been determined in step S 122, where diff of the multicast packet m to be stored in the first buffer is compared with the multicast packet n to be stored in the second buffer, that the multicast packet n is the same as the multicast packet m, the multicast packet n is incremented by "1" so that the next multicast packet is stored in the second buffer (S118), and then the process proceeds to step S 119. This is to perform an operation on the next multicast packet since the multicast packet presenting the FEC data is the same as the multicast packet presenting the piece.

As described above, according to the digital broadcasting system and the error correction method thereof of the present invention, the FEC data for lost-packet recovery is included in the multicast packet in the FEC group and transmitted, thereby reducing a network load.

While the present invention has been described with reference to exemplary embodiments thereof, it will be understood by those skilled in the art that various modifications in form and detail may be made therein without departing from the scope of the present invention as defined by the following claims.

**Claims**

1. A digital broadcasting system comprising:

a server to group a predetermined number of multicast packets to obtain Forward Error Correction (FEC) groups for digital broadcast data (MPEG TS) transmission, to create FEC data for each multicast packet using the digital broadcast data (MPEG TS) of the multicast packets in the FEC groups, including the FEC data in the multicast packets, and to transmit the resultant multicast packets over a network; and
a set-top box to recover respective digital broadcast data (MPEG TS) pieces of the lost multicast packet through digital broadcast data (MPEG TS) pieces of multicast packets other than the lost multicast packet and to combine the recovered digital broadcast data (MPEG TS) pieces to recover the lost multicast packet in response to a multicast packet received over the network being lost.

2. The system of claim 1, wherein the server comprises:

obtain the multicast FEC groups for digital broadcast data (MPEG TS) transmission;
a data fragmenter to fragment the digital broadcast data (MPEG TS) of the multicast packets in the FEC groups by the set number;
an FEC data setter to fragment the respective digital broadcast data (MPEG TS) of the multicast packets in the FEC groups by the set number, to set the FEC data for each multicast packet through an exclusive OR (XOR) operation performed on the fragmented digital broadcast data (MPEG TS), including the FEC data in the multicast packets, and to transmit the resultant multicast packets over the network; and
an FEC header setter to set a stream ID, a sequence number, and an order of each multicast packet in the FEC groups, and including the stream ID, the sequence number, and the order in each multicast packet.

3. The system of claim 2, wherein the set-top box determines whether there is a lost packet based on the sequence number.

4. A server for a digital broadcasting system, the server comprising:

a Forward Error Correction (FEC) group setter to group a predetermined number of multicast packets to obtain FEC groups for digital broadcast data (MPEG TS) transmission;
a data fragmenter to fragment the digital broadcast data (MPEG TS) of the multicast packets in the FEC groups by a set number; and
an FEC data setter to fragment the digital broadcast data of the multicast packets in the FEC groups by a set number, to set FEC data for each multicast packet through an exclusive OR (XOR) operation performed on the fragmented digital broadcast data (MPEG TS), including the FEC data in the multicast packets, and to transmit the resultant multicast packets over the network.

5. The server of claim 4, further comprising an FEC header setter to set a stream ID, a sequence number, and an order of each multicast packet in the FEC group and including the stream ID, the sequence number, and the order in each multicast packet.

6. A set-top box for a digital broadcasting system, the set-top box comprising:

an error determiner to determine whether any multicast packet received over a network has been lost, based on a sequence number contained in a multicast packet;
at least one buffer; and
an error corrector to recover the lost multicast packet through recovery of Forward Error Correction (FEC) data of multicast packets other than the lost multicast packet in an FEC group.

7. The set-top box of claim 6, wherein the error corrector checks a multicast packet having FEC data to be recovered and a location of a digital broadcast data (MPEG TS) piece of the multicast packet, stores the FEC data in a first buffer, extracts respective digital broadcast data (MPEG TS) pieces required for recovery from multicast packets other than the multicast packet having the stored FEC data and the lost multicast packet, and performs an XOR operation on each extracted digital broadcast data (MPEG TS) piece and the FEC data stored in the first buffer to recover a P-th digital broadcast data (MPEG TS) piece of the lost multicast packet, and
the error corrector further recovers respective digital broadcast data (MPEG TS) pieces of the lost multicast packet through FEC data of multicast packets other than the lost multicast packet in the FEC group, and combines the recovered digital broadcast data (MPEG TS) pieces to recover the digital broadcast data (MPEG TS) of the lost multicast packet.

8. A method of setting error correction information in a server for a digital broadcasting system, the method comprising:

grouping a predetermined number of multicast packets to obtain FEC groups for digital broadcast data (MPEG TS) transmission;
fragmenting digital broadcast data (MPEG TS) of the multicast packets in the FEC groups by a set number; and
fragmenting digital broadcast data (MPEG TS) of the multicast packets in the FEC groups by a set number, setting Forward Error Correction (FEC) information for each multicast packet by using the fragmented digital broadcast data (MPEG TS), including the FEC data in the multicast packets, and transmitting the resultant multicast packets over a network.

9. The method of claim 8, wherein fragmenting digital broadcast data (MPEG TS) of the multicast packets in the FEC groups by a set number, setting FEC data for each multicast packet by using the fragmented digital broadcast data (MPEG TS), including the FEC data into the multicast packets, and transmitting the resultant multicast packets over a network comprises setting FEC data for each multicast packet through an exclusive OR (XOR) operation performed on the fragmented digital broadcast data (MPEG TS).

10. The method of claim 8, further comprising setting a stream ID, a sequence number, and an order of each multicast packet in the FEC groups, and including the stream ID, the sequence number, and the order in each multicast packet.

11. A method of error correction in a set-top box for a digital broadcasting system, the method comprising:

determining whether any multicast packet received over a network has been lost, based on a sequence number contained in each multicast packet; and
recovering digital broadcast data (MPEG TS) pieces of the lost multicast packet through FEC data of multicast packets other than the lost multicast packet in a EFC group and combining the recovered digital broadcast data (MPEG TS) pieces to recover the lost multicast packet.

# FIG. 1

| ORIGINAL PACKET | A | B | C | D | E | ... |
|---|---|---|---|---|---|---|
| FEC APPLIED | A | f(A,B) | B | f(B,C) | C | ... |

EP 1 950 969 A2

# FIG. 2

# FIG. 3

FEC HEADER SETTER 32

STREAM SERVER → FEC GROUP SETTER 31

STREAM ID SETTER 33

SEQUENCE NUMBER SETTER 34

ORDER SETTER 35

FEC DATA SETTER 36

FIRST BUFFER 37

SECOND BUFFER 38

DATA FRAGMENTER 39

IP NETWORK

# FIG. 4

SET-TOP BOX

IP NETWORK → NETWORK INTERFACE (41) → ERROR DETERMINER (42) → ERROR CORRECTOR (43) → DIGITAL TELEVISION

EP 1 950 969 A2

# FIG. 5

| | |
|---|---|
| 50 | IP (20byte) |
| 51 | UDP (8byte) |
| 52 | MPEG TS (1316byte) |
| 53 | FEC HEADER |
| 54 | FEC DATA |

0

20byte

28byte

1344byte

1352byte

1500byte (MTU)

# FIG. 6

| 1byte | 2byte | 3byte | 4byte |
|---|---|---|---|
| GROUP_SIZE | STREAM_ID | | |
| DIFF | FRAGMENT_SIZE | SEQUENCE_NUMBER | |

# FIG. 7

| | MPEG-TS DATA(1316byte) | | | | | | | | |
|---|---|---|---|---|---|---|---|---|---|
| NUMBER | 0 | 1 | 2 | 3 | 4 | 5 | 6 | 7 | 8 |
| DATA RANGE (byte) | 0 ~ 147 | 148 ~ 295 | 296 ~ 443 | 444 ~ 591 | 592 ~ 739 | 740 ~ 887 | 888 ~ 1035 | 1036 ~ 1183 | 1184 ~ 1315 |
| SIZE(byte)/ FRAGMENT_SIZE | 148 | 148 | 148 | 148 | 148 | 148 | 148 | 148 | 132 |

# FIG. 8

| PACKET NAME | A | B | C | D | E | F | G | H | I | J |
|---|---|---|---|---|---|---|---|---|---|---|
| GROUP SIZE | 10 | 10 | 10 | 10 | 10 | 10 | 10 | 10 | 10 | 10 |
| SEQUENCE NUMBER | 100 | 101 | 102 | 103 | 104 | 105 | 106 | 107 | 108 | 109 |
| DIFF | 0 | 1 | 2 | 3 | 4 | 5 | 6 | 7 | 8 | 9 |
| PIECE NUMBER FOR FEC DATA CREATION | B0 C0 D0 E0 F0 G0 H0 I0 J0 | A0 C1 D1 E1 F1 G1 H1 I1 J1 | A1 B1 D2 E2 F2 G2 H2 I2 J2 | A2 B2 C2 E3 F3 G3 H3 I3 J3 | A3 B3 C3 D3 F4 G4 H4 I4 J4 | A4 B4 C4 D4 E4 H5 I5 J5 | A5 B5 C5 D5 E5 F5 G5 H6 I6 J6 | A6 B6 C6 D6 E6 F6 G6 I7 J7 | A7 B7 C7 D7 E7 F7 G7 H7 J8 | A8 B8 C8 D8 E8 F8 G8 H8 I8 |

EP 1 950 969 A2

## FIG. 9

START

S90
INITIALIZATION

S91
DOES COUNTER (N) ORDER OF PACKET MATCH ORDER DIFF OF PACKET FOR WHICH FEC DATA IS TO BE SET?

NO →

S94
n=n+1

S92
STORE (DIFF-1)-TH MPEG TS PIECE OF N-TH PACKET IN FEC GROUP IN SECOND BUFFER

S93
PERFORM XOR OPERATION ON VALUE OF FIRST BUFFER AND VALUE OF SECOND BUFFER AND STORE RESULTANT VALUE IN FIRST BUFFER

YES ↓

S95
n=diff+1

S96
DOES COUNTER (N) ORDER OF PACKET MATCH FEC GROUP SIZE?

NO →

S99
n=n+1

S97
STORE DIFF-TH MPEG TS PIECE OF N-TH PACKET IN FEC GROUP IN SECOND BUFFER

S98
PERFORM XOR OPERATION ON VALUE OF FIRST BUFFER AND VALUE OF SECOND BUFFER AND STORE RESULTANT VALUE IN FIRST BUFFER

YES ↓

S100
INCLUDE FEC DATA IN MULTICAST PACKET AND TRANSMIT IT

END

EP 1 950 969 A2

# FIG. 10

START

S200
RECEIVE MULTICAST? — NO

YES

S201
SAME FEC GROUP? — NO → S202 STORE IN FEC HEADER BUFFER AND TS BUFFER

YES

S203
IS PACKET LOST? — YES → S205 RECOVER

NO

S204 STORE IN FEC HEADER BUFFER AND TS BUFFER AND SEND DIGITAL BROADCAST DATA TO DECODER

END

# FIG. 11

START — S110

m=0

S112
m=m+1

S111
COMPARE M WITH DIFF OF LOST PACKET

m > diff

m==diff

m < diff

S113
P=m−1

P=m — S114

S115
if(m < group_size)

NO → S116
OUTPUT CONTENT OF THIRD BUFFER TO TS BUFFER

END

YES — S117
FIRST BUFFER = FEC DATA OF PACKET M SECOND BUFFER, N = 0 (INITIALIZATION)

S118
n=n+1

S119
if(n < group_size)

NO → S120
STORE INFORMATION OF FIRST BUFFER AT P−TH PIECE LOCATION OF THIRD BUFFER

YES — S121
IF(N== DIFF OF LOST PACKET)

YES

NO

S122
COMPARE N WITH M

n==diff

n > diff

n < diff

S123
STORE (M−1)-TH PIECE OF N-TH PACKET IN CURRENT FEC GROUP IN SECOND BUFFER (REMAINING SPACE OF BUFFER IS FILLED WITH 0)

S124
STORE M-TH PIECE OF N-TH PACKET IN CURRENT FEC GROUP IN SECOND BUFFER (REMAINING SPACE OF BUFFER IS FILLED WITH 0)

STORE RESULT OF XOR OPERATION PERFORMED ON CONTENTS OF FIRST AND SECOND BUFFERS IN FIRST BUFFER — S125